# EUROPEAN PATENT SPECIFICATION

(11) **EP 4 399 796 B1**
(45) Date of publication and mention of the grant of the patent: **04.11.2026**
(21) Application number: 22754640.5
(22) Date of filing: 21.07.2022
(51) Int. Cl.: H03F 1/32, H03F 1/42, H03F 3/193, H03F 3/21, H03F 3/60

(54) **BALANCED AMPLIFIERS WITH WIDEBAND LINEARIZATION**
SYMMETRISCHE VERSTÄRKER MIT BREITBANDLINEARISIERUNG
AMPLIFICATEURS SYMÉTRIQUES À LINÉARISATION LARGE BANDE

(30) Priority: 10.09.2021 US 202117471535
(43) Date of publication of application: 17.07.2024
(73) Proprietor: Northrop Grumman Systems Corporation, Falls Church, VA 22042 (US)
(72) Inventor: GHANEVATI, Manouchehr, Laguna Niguel, CA 92677 (US); SIDDIQUI, Mansoor, K., Torrance, CA 90505 (US); MILLER, David, J., Torrance, CA 90502 (US); HERNDON, Michael, Lakewood, CA 90713 (US)
(74) Representative: Studio Torta S.p.A.
(86) International application number: PCT/US2022/037796
(87) International publication number: WO 2023/038721

(56) References cited:
- US-A1- 2004 239 429
- ZHANG J ET AL: "Linearity improvement using a modified derivative superposition method in cascaded stages amplifier", IET MICROWAVES, ANTENNAS & PROPAGATION, THE INSTITUTION OF ENGINEERING AND TECHNOLOGY, UNITED KINGDOM, vol. 6, no. 8, 7 June 2012 (2012-06-07), pages 922 - 928, XP006042541, ISSN: 1751-8725, DOI: 10.1049/IET-MAP.2011.0561
- SAINI KANIKA ET AL: "Computer-aided design methodology for linearity enhancement of multiwatt GaN HEMT amplifiers using multiple parallel devices", INTERNATIONAL JOURNAL OF RF AND MICROWAVE COMPUTER-AIDED ENGINEERING, vol. 30, no. 1, 25 January 2020 (2020-01-25), XP055975017, ISSN: 1096-4290, Retrieved from the Internet <URL:https://onlinelibrary.wiley.com/doi/full-xml/10.1002/mmce.22010> DOI: 10.1002/mmce.22010
- PARK HONGWOO ET AL: "Broadband Tunable Third-Order IMD Cancellation Using Left-Handed Transmission-Line-Based Phase Shifter", IEEE MICROWAVE AND WIRELESS COMPONENTS LETTERS, IEEE SERVICE CENTER, NEW YORK, NY, US, vol. 25, no. 7, 2 July 2015 (2015-07-02), pages 478 - 480, XP011662390, ISSN: 1531-1309, [retrieved on 20150702], DOI: 10.1109/LMWC.2015.2427655

## Description

### Technical Field

Embodiments of the invention relate to balanced amplifiers and more specifically to balanced amplifiers in which linearization is desired over a wide bandwidth.

### Background

Various linearization schemes have been applied to linear amplifiers and high-power amplifiers, in particular, to improve both the linearity as well as the efficiency of amplifiers. For example, a single active amplifier may have an output in which the gain varies over a certain frequency range and input power level. In an attempt to compensate for this change in gain, a circuit that varies with frequency may be used in an attempt to compensate for the gain change of the active device with frequency in order to improve linearity of the amplifier within a frequency range. For example, the circuit may cause the gain of the amplifier to increase as input power increases while the uncompensated gain of the active device is decreasing. Thus, the overall amplifier gain remains relatively constant over a wider range of input power than if compensation were not employed.

Balanced amplifiers tend to have good input and output matching, and frequency stability. Additionally, higher reliability is achieved since the overall amplifier will continue to function, although at a less than optimal level, even if one amplifier fails. Even using balanced amplifiers, linearity over a desired bandwidth may not be achievable. Therefore, there exists a need for a balanced amplifier with improved linearity over a wide bandwidth. Examples of linearised amplifiers of the prior art are shown in non-patent document ZHANG J ET AL: "Linearity improvement using a modified derivative superposition method in cascaded stages amplifier", IET MICROWAVES, ANTENNAS & PROPAGATION, vol. 6, no. 8, 7 June 2012, pages 922-928, , ISSN: 1751-8725, DOI: 10.1049/ IET-MAP.2011.0561, non-patent document SAINI KANIKA ET AL: "Computer-aided design methodology for linearity enhancement of multiwatt GaN HEMT amplifiers using multiple parallel devices", INTERNATIONAL JOURNAL OF RF AND MICROWAVE COMPUTER-AIDED ENGINEERING, vol. 30, no. 1, 25 January 2020 (2020-01-25), ISSN: 1096-4290, DOI: 10.1002/ mmce.22010, and patent document US 2004/239429 A1.

### Summary

An object of the present invention is to provide a solution for the above referenced need.

In one embodiment, an RF amplifier utilizes first and second main amplifiers in a balanced amplifier configuration with first and second auxiliary amplifiers connected in parallel across the first and second main amplifiers, respectively. The main and the auxiliary amplifiers are biased in an operating region such that the third-order nonlinearity components in the output from the main amplifiers have one of a positive and negative slope and the third-order nonlinearity components in the output from the auxiliary amplifiers have the other of a positive and negative slope so that the third-order nonlinearity components destructively combine to reduce total magnitude of third order nonlinearity components. A bias control circuit controls the DC operating region of the auxiliary amplifiers.

In another embodiment, a phase shift of an input to one auxiliary amplifier is used to provide a peak in minimization of the third order nonlinearity components at a frequency associated with the phase shift. In a further embodiment, one or more phase shifts of an input to one auxiliary amplifier is used to provide corresponding one or more peaks in minimization at frequencies associated with the one or more phase shifts.

A method that is implemented by the described devices and circuitry is also provided.

### Brief Description of the Drawings

Features of exemplary implementations of the invention will become apparent from the description, the claims, and the accompanying drawings in which:
FIG. 1 is a diagram of an exemplary embodiment of a balanced amplifier in which linearization which is not covered by the claimed invention has been incorporated.
FIG. 2 is a diagram of another exemplary embodiment of a balanced amplifier in which linearization which is covered by the claimed invention has been incorporated.
FIG. 3 is a diagram of selectable phase shifters which can be utilized with the embodiment of FIG. 2.
FIG. 4 is an exemplary schematic diagram for a balanced amplifier that does not incorporate linearization improvements in accordance with the present invention.
FIG. 5 shows exemplary RF performance of the balanced amplifier of FIG. 4.
FIG. 6 is a simplified exemplary schematic diagram of an embodiment of a linearized balanced amplifier with tunable single-mode operation which is not covered by the claimed invention.
FIG. 7 illustrates operating bias points for main and auxiliary devices.
FIG. 8 shows exemplary RF performance of a linearized balanced amplifier embodiment at input power level of -30 dBm.
FIG. 9 shows exemplary RF performance of the linearized balanced amplifier embodiment at input power level of -30 dBm and 0 dBm.
FIG. 10 shows graphs of input power vs. output power (PIPO) for the linearized balanced amplifier embodiment over the frequency range of 25 - 29 GHz and input power level -10 to +20 dBm.
FIG. 11 is a graph showing noise figure performance of a linearized balanced amplifier embodiment relative to a balanced amplifier without linearization.
FIG. 12 is a simplified schematic diagram of the linearized balanced amplifier embodiment with tunable dual-mode operation which is covered by the claimed invention.
FIG. 13 shows graphs of RF performance of the linearized balanced amplifier embodiment with single mode linearization peaking vs. gate control voltage for the auxiliary amplifier.
FIG. 14 shows graphs of RF performance of the linearized balanced amplifier embodiment with dual mode linearization peaking vs. gate control voltage for the auxiliary amplifier.
FIG. 15 shows graphs of RF performance of the linearized balanced amplifier embodiment with dual mode linearization peaking vs. gate control voltage for the auxiliary device where the active devices are sized differently to further enhance linearization performance.
Hereinafter, whenever an embodiment is described, reference is to be made to the above figure list to determine whether the embodiment is to be read as covered by the claimed invention or as an embodiment which is not covered by the claimed invention.

### Detailed Description

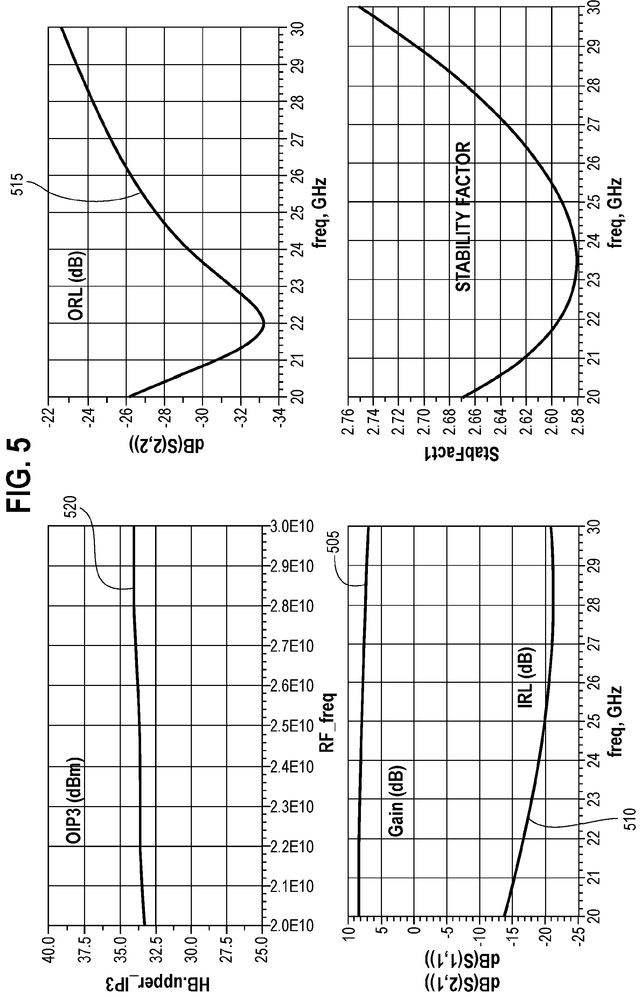

A balanced amplifier, without linearization in accordance with the present invention, that is suitable for operation between 20 and 30 GHz is described and its performance shown in FIG. 5 to establish performance for comparison with the performance of the embodiments of linearized balanced amplifiers in accordance with the present invention. Embodiments of linearized balanced amplifiers utilize auxiliary devices with constant and/or variable gate bias control and physical sizing which are incorporated as part of circuitry associated with a balanced amplifier circuit. The auxiliary amplifiers are preferably biased differently than the main amplifier of the balanced amplifier circuit. The currents of the main and auxiliary amplifiers are summed at the output/load to enhance overall amplifier linearity. At a certain input power level, the gain of the auxiliary amplifier(s) increases while the gain of the main amplifier starts to decrease. Thus, the gain of the entire balanced amplifier circuitry will remain substantially constant over a wide range of input power resulting in amplifier linearization.

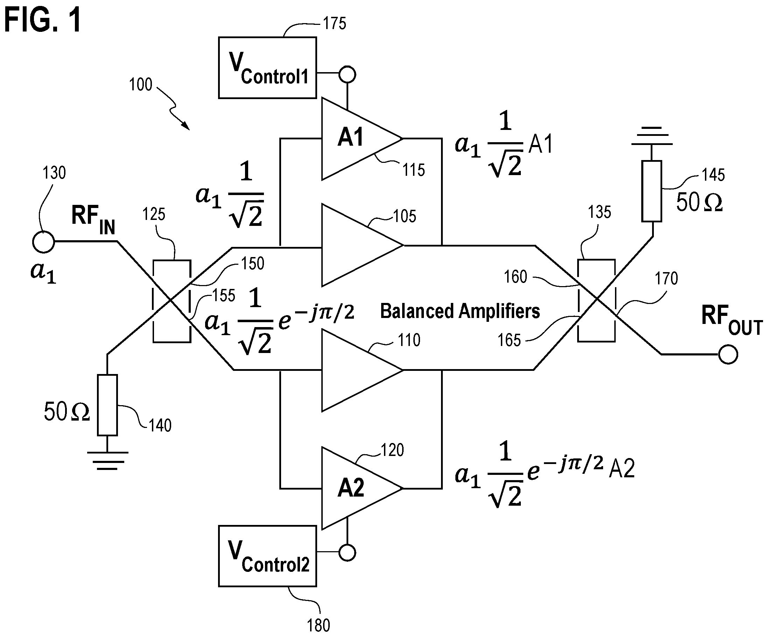

FIG. 1 illustrates the concept of linearizing a balanced amplifier circuit 100 having balanced amplifiers 105 and 110 by incorporating auxiliary amplifiers 115 and 120. The balanced amplifier circuit 100 may include an input Lange coupler 125 for distributing the RF input signal from the input RF port 130, identical amplifiers 105, 110 and preferably RF transitions between two output ports of the Lange coupler 125 and the respective inputs of the balanced amplifiers 105, 110. Preferably, substantially identical RF transitions are provided from the respective outputs of the balanced amplifiers 105, 100 to two ports of the output Lange coupler 135. The Lange couplers are a 4-port device but since one of each of its ports is isolated by a 50 ohm load 140, 145, it may be considered as a 3-port device. The input RF signal at port 130 enters an input of the Lange coupler 125, and is equally divided between the ports 150 and 155 with 90-degree phase difference. These divided signals are respective inputs to the balanced amplifiers 105, 100 which provide amplification of the respective divided signals. The amplified divided signals provide inputs to the Lange coupler inputs 160, 165. The signal at input 165 is phase shifted by 90 degrees so that this shifted signal will be in-phase with the signal at input 160. These in-phase signals are combined at the output port 170 of the Lange coupler that acts as a power combiner.

FIG. 1 also shows auxiliary amplifiers A1 115 and A2 120 that are connected in parallel across the main amplifiers 105 and 110, respectively. The input RF signals to the main amplifiers 105, 110 also serve as inputs of the auxiliary amplifiers 115, 120. The main and auxiliary amplifier pairs share the identical load and their output currents combine at the load. The DC bias currents through the auxiliary amplifiers 115, 120 are controlled by adjusting V_{control1} 175 and V_{control2} 180, each of which may be an adjustable DC voltage power supply. The signals through the upper arm (path) which includes main amplifier 105 and lower arm which includes main amplifier 110 of the balanced amplifier are in phase quadrature (90° phase difference). The signal at input 160 is combined with the 90 degree phase shifted signal 165 by coupler 135 so that the in-phase signals are constructively combined at output 170. This linearization scheme results in single-mode linearization within the frequency band of operation. A single mode is referred to as a single frequency.

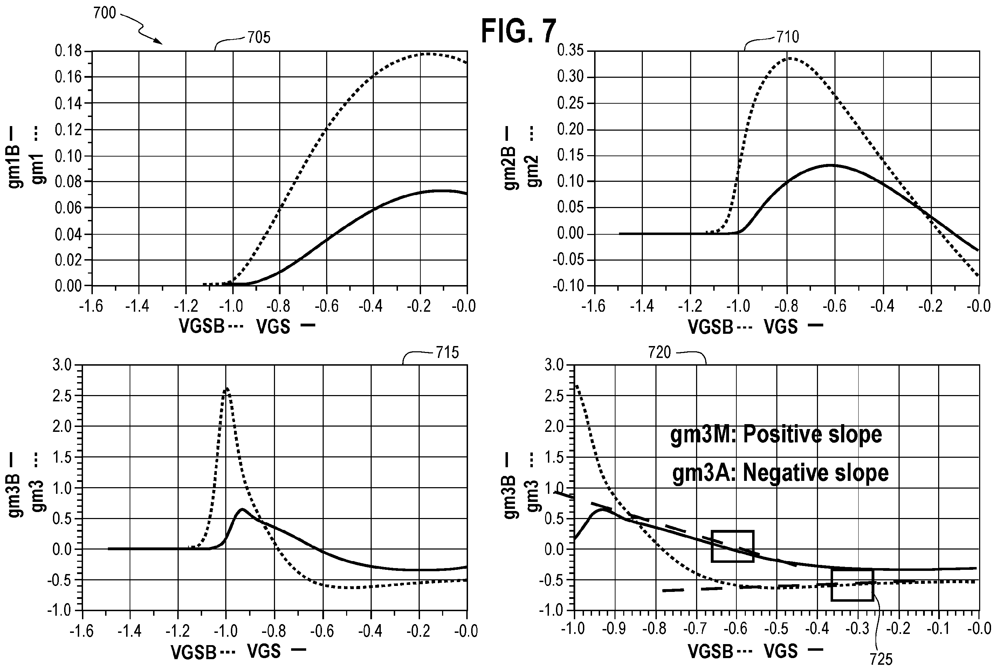

For a weakly nonlinear device, the output drain current for main (_{M}) and auxiliary (_{A}) amplifiers can be written as below: ${i}_{M} = {g}_{1 M} {v}_{gs} + {g}_{2 M} {{v}_{gs}}^{2} + {g}_{3 M} {{v}_{gs}}^{3}$ ${i}_{A} = {g}_{1 A} {v}_{gs} + {g}_{2 A} {{v}_{gs}}^{2} + {g}_{3 A} {{v}_{gs}}^{3}$ ${i}_{total} = {i}_{M} + {i}_{A}$ Where,
*i_{M} = output drain current for the main amplifier*
*i_{A} = output drain current for the auxiliary amplifier*
*v_{gs} = gate to source voltage of the device* ${i}_{total} = {i}_{M} + {i}_{A} = sum of drain currents for the main and auxiliary amplifiers$
*g*₁*_{M} and g*₁*_{A} are derivative of drain current with respect to v_{gs}*
*g*₂*_{M} and g*₂*_{A} are second derivative of drain current with respect to v_{gs}*
*g*₃*_{M} and g*₃*_{A} are third derivative of drain current with respect to v_{gs}*
To improve IIP3/OIP3 (Input/Output Third-order Intercept Points)
derivative superposition would suggest that $total {g}_{3} = {g}_{3 M} + {g}_{3 A} should be minimized ,$
where, ${g}_{1} = C 1 \frac{\partial {i}_{D}}{\partial \left(Vgs\right)} , {g}_{2} = C 2 \frac{{\partial }^{2} {i}_{D}}{\partial \left({V}^{2}gs\right)} , {g}_{3} = C 3 \frac{{\partial }^{3} {i}_{D}}{\partial \left({V}^{3}gs\right)}$
where C1, C2, C3 are constant quantities.
Therefore, it is deduced that the slope of *g*_{3*M*} and *g*_{3*A*} versus *Vgs* should be opposite in order to achieve as much cancellation as possible of the third order nonlinearity components (i.e., *v_{gs}*³). As seen in FIG. 7, graph 720 is a plot of g3M and g3A which are the third derivative of Id (drain current) with respect to Vgs. If the overall g3 is reduced, third order intermodulation products are reduced and OIP3 or IIP3 is improved. The main and auxiliary amplifiers are preferably biased at regions of *Vgs* where the slope for *g*_{3*M*} and *g*_{3*A*} are opposite, i.e., have opposite slopes. Referring to FIG. 1: ${a}_{1} \frac{1}{\sqrt{2}} A 1 \frac{1}{\sqrt{2}} {e}^{- jπ / 2} = output signal due to auxiliary amplifier A 1$ ${a}_{1} \frac{1}{\sqrt{2}} {e}^{- jπ / 2} A 2 \frac{1}{\sqrt{2}} = output signal due to auxiliary amplifier A 2$ $\frac{1}{2} {a}_{1} \left(A1+A2\right) {e}^{- jπ / 2} = output signal due to both auxiliary amplifiers$

The exemplary embodiments of the invention utilize the integration of auxiliary amplifiers with respective main amplifiers in each branch of a balanced amplifier. Factors that can contribute to linearization include the sizing of auxiliary amplifiers relative to the respective main amplifiers, dynamic bias control to achieve as much cancellation of *g*_{3*M*} versus *g*_{3*A*} as possible, multi-biasing, i.e., using independent gate bias control for each auxiliary device to maximize cancellation of the third order nonlinearity components, and utilization of a transmission line, e.g., a quarter-wave transmission line, to change the phase of the input signal to one auxiliary amplifier in only one branch of the balanced amplifier. Linearization techniques are shown over a frequency range and as a function of input RF power drive.

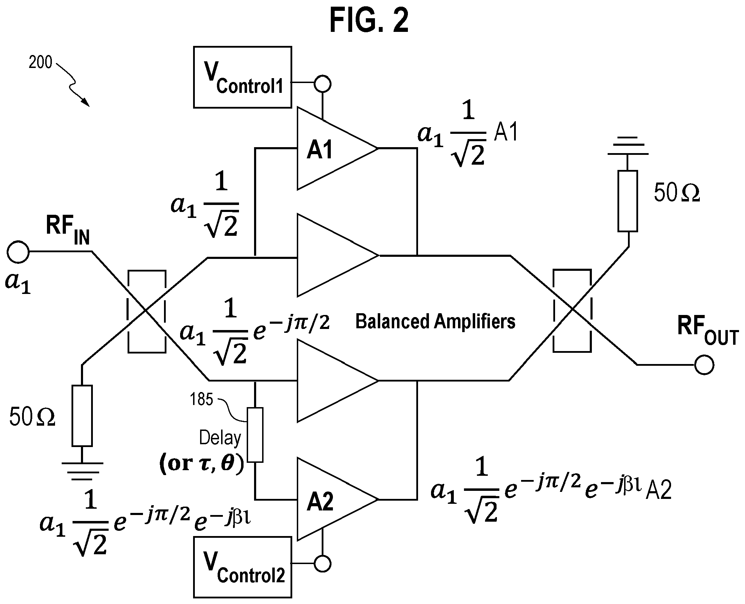

Fig. 2 shows another embodiment 200 of linearization of a balanced amplifier in which two modes (frequencies) within the overall bandwidth of operation are linearized. It will be apparent that the embodiment 200 is very similar to embodiment 100, and the like elements function similarly. Hence only differences between these embodiments will be described. In embodiment 200, a transmission line, e.g., λ/4 transmission line, 185 provides a 90 degree phase shift at a selected frequency within the intended frequency range of operation and is connected in series with the input to one of the auxiliary amplifiers. This results in two modes of operation due to the 90° resultant phase at the load in one arm relative to the other arm. The 90° phase line 185 can be obtained by using a transmission line that functions as a delay line, a phase shifter such as a shift register in the digital domain, or other known phase shifting techniques. Referring to FIG. 2:
${a}_{1} \frac{1}{\sqrt{2}} A 1 \frac{1}{\sqrt{2}} {e}^{- jπ / 2} = output signal due to auxiliary amplifier A 1$
${a}_{1} \frac{1}{\sqrt{2}} {e}^{- jπ / 2} {e}^{- jπ / 2} A 2 \frac{1}{\sqrt{2}} = output signal due to auxiliary amplifier A 2$ $\begin{matrix}\frac{1}{2} {a}_{1} A 1 {e}^{- jπ / 2} + \frac{1}{2} {a}_{1} A 2 {e}^{- jπ} = \\ output signal due to both auxiliary amplifiers\end{matrix}$

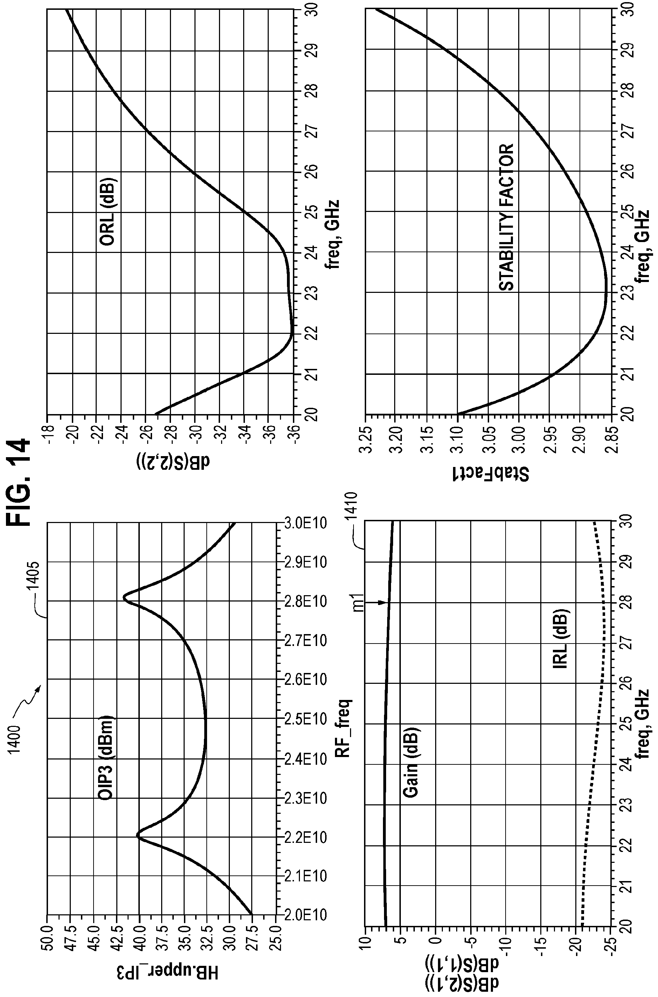

The minimization peaks in third order nonlinearity components for two modes are shown in the graph 1405 of FIG. 14.

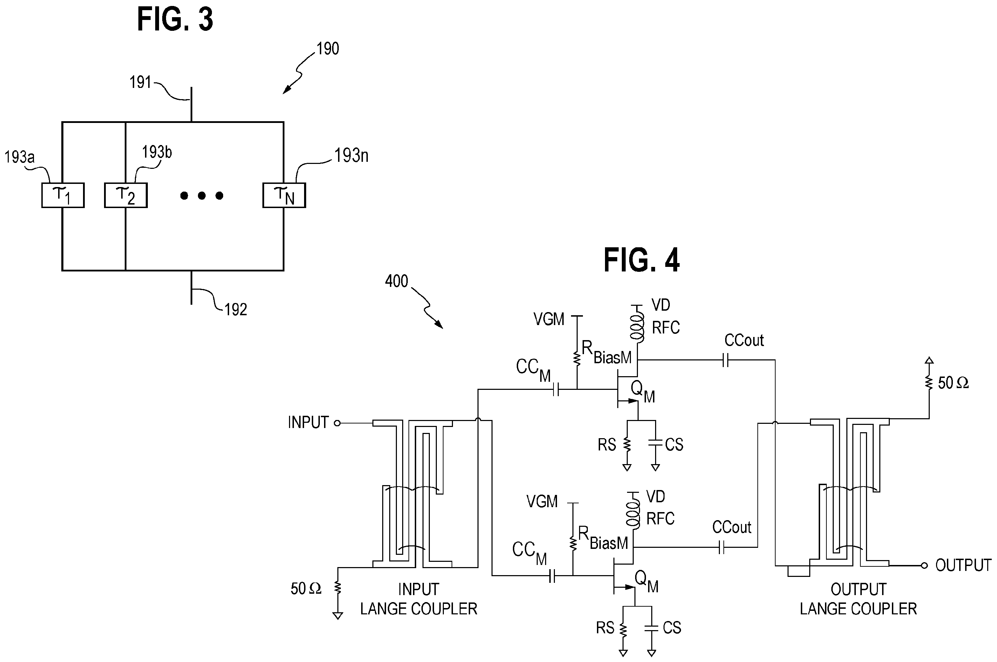

FIG. 3 shows an apparatus 190 that can be utilized in place of delay line 185 of FIG. 2 to provide selectable frequencies at which a 90 degree phase shift occurs. This provides the capability for a balanced amplifier having a tunable multi-mode operation. The selectable (switchable) delay apparatus 190 replaces the transmission line (λ/4 line or the phase shifter 185) in FIG. 2. This arrangement allows for dynamic multi-mode operation by selecting one of the delay elements having a 90° phase at a selected frequency. Input 191 receives the signal to be delayed and output 192 is the output for the delayed signal that is coupled to the auxiliary amplifier. Only one of the delay elements 193a, 193b, ..., 193n, each with a 90° phase shift at a different frequency within the intended range of operation, is selected at a given time to provide the desired phase shift at a selected frequency. Using different gate control voltages for auxiliary amplifiers as explained above for FIG. 1 to enhance cancellation of third order nonlinearity products can be combined with frequency tuning by the selectable delay 190 to provide peaks in linearization of the linearized balanced amplifier.

FIG. 4 depicts a simplified schematic diagram for a non-linearized balanced amplifier 400 (without auxiliary amplifiers) that uses 0.15 um GaAs HEMT technology for 20 - 30 GHz operation. The upper and lower active HEMT devices Q_{M} are identical in size (a total periphery of 360 um) and have identical biasing conditions. Input power divider and combiner are Lange couplers. Capacitors CC_{M} and CCout are DC blocking capacitors used at the input and output of each device, Q_{M}. The transistor Qm is biased at the gate using gate resistor R_{biasM} coupled to control gate voltage VGM. Biasing of the main drain/source channel is accomplished using DC voltage VD and DC current limiting resistor RS. The radio frequency choke (RF impedance) RFC provides the proper RF voltage swing at the output of the device. The capacitor CS is an RF bypass capacitor for RS, short-circuiting RS at RF frequencies with the bandwidth of operation.

FIG. 5 shows the overall performance for the balanced amplifier 400. Gain 505 greater than 7 dB has been achieved across the frequency band of 20 GHz to 30 GHz. Good input return loss (IRL) 510 and output return loss (ORL) 515 as shown are achieved over the bandwidth frequency of design. The simulated OIP3 520 is about 33 dBm.

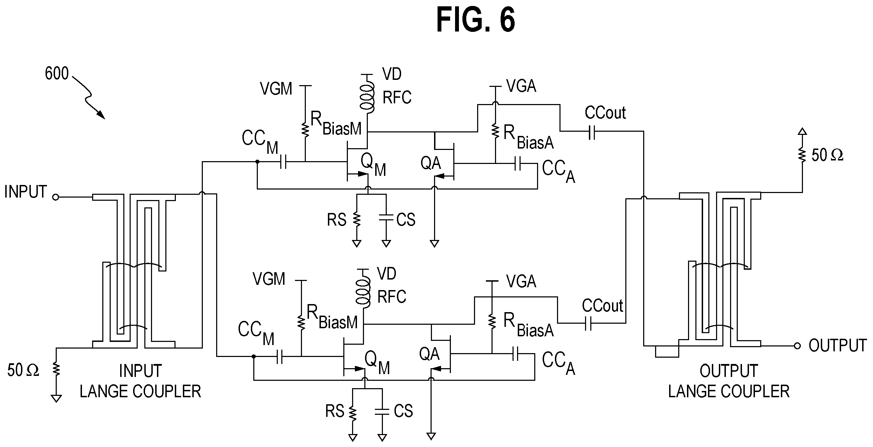

FIG. 6 shows one embodiment 600 in accordance with the present invention of a linearized balanced amplifier for single-mode operation. Embodiment 600 is an exemplary representation of one implementation of embodiment 100. Transistors QA's are the auxiliary devices that are connected in parallel with main devices, QM's. Transistors QA's use DC blocking capacitors CC_{A} to allow for different gate biasing than transistors QM, and share the drain bias line and RFC at the output with the respective QM's. Transistors QA use separate gate bias line and control voltage for biasing their gates (i.e., R_{biasA} and VGA) that differ from the biasing of main amplifiers QMs. The total periphery of the respective devices is 120um for the auxiliary devices and 360umum for the main amplifiers.

FIG. 7 shows graphs 700 which illustrate the operating bias points for the main and auxiliary devices for the embodiment 600. Plots of Id vs. Vgs (not shown) for both auxiliary and main devices are assumed to be known, or can be determined by test. By taking the derivative of Id vs. Vgs, gm1 plot 705 is obtained. In all the graphs of FIG. 7, the darker line represents the gm for the auxiliary device and lighter line represents the gm for the main device. Plots of gm2 710 and gm3 715 are determined by taking consecutive derivatives of plot 705. The DC operating points, vgs, for the main and auxiliary device are selected at regions 725 and 735 on the respective gm3 line 730 for the main device and line 740 for the auxiliary device. The combined main and auxiliary device output current due to gm3 is minimized since gm3M at region 725 for the main device has an opposite slope from gm3A at region 735 for the auxiliary device. Thus, the main and auxiliary device gm3's cause respective output currents Id due to gm3 to cancel and hence minimize the undesired third order nonlinearity products.

Further improvements in cancellation can be achieved by selecting the gain of the main and auxiliary devices so that the respective gm3 gains are substantially equal to enhance the cancellation of third order nonlinearity products. In the example as shown in graph 720, the gm3 gain at region 725 for the main device is less than the gm3 gain at region 735 for the auxiliary device. Thus, for improved gm3 cancellation, the respective gains for the main and auxiliary devices should be adjusted so that components in the respective Id currents due to gm3 are the same and hence promote cancellation since the gm3 slopes differ. The physical size of the devices is generally proportional to the gain of the devices so the main and auxiliary devices can be designed to have a size, and hence gain, that will satisfy the desire to have output currents due to gm3 that cancel.

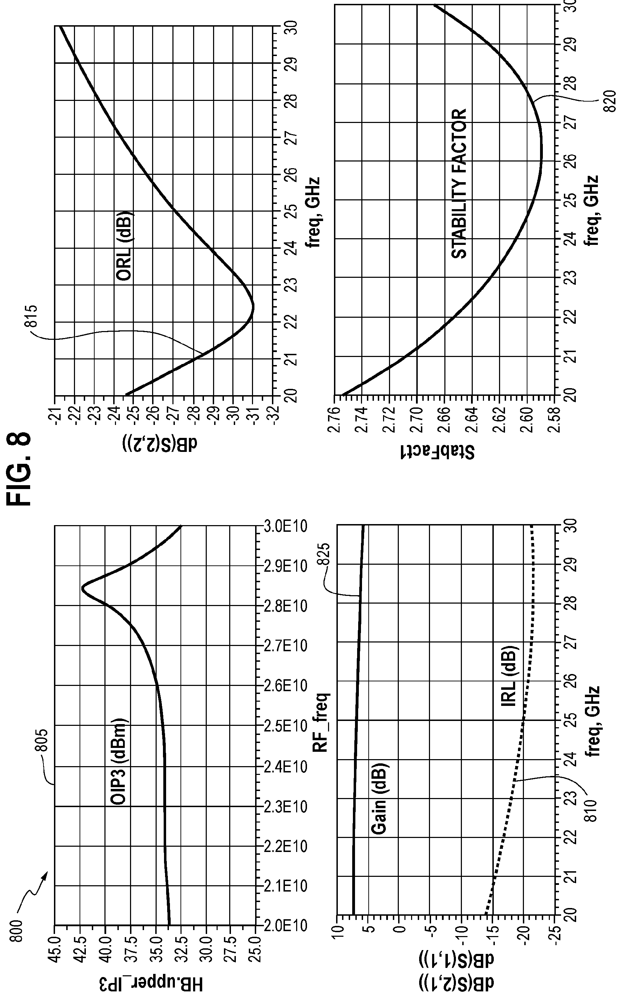

FIG. 8 shows graphs 800 of the performance of the linearized amplifier 600 with an RF input signal of -30 dBm. Graph 805 shows that OIP3 peaks at about 42 dBm at upper frequency end of the band, e.g., about 28.5 GHz, and stays between 33 - 35 dBm from 20 GHz to 26 GHz. Excellent input RL 810 and output RL 815 as shown have been achieved. Simulated stability factor, K, 820 greater than 3.35 over the frequency range is shown. The gain, S21, 825 gradually decreases from 7 dB at 20 GHz to about 6 dB at 30 GHz.

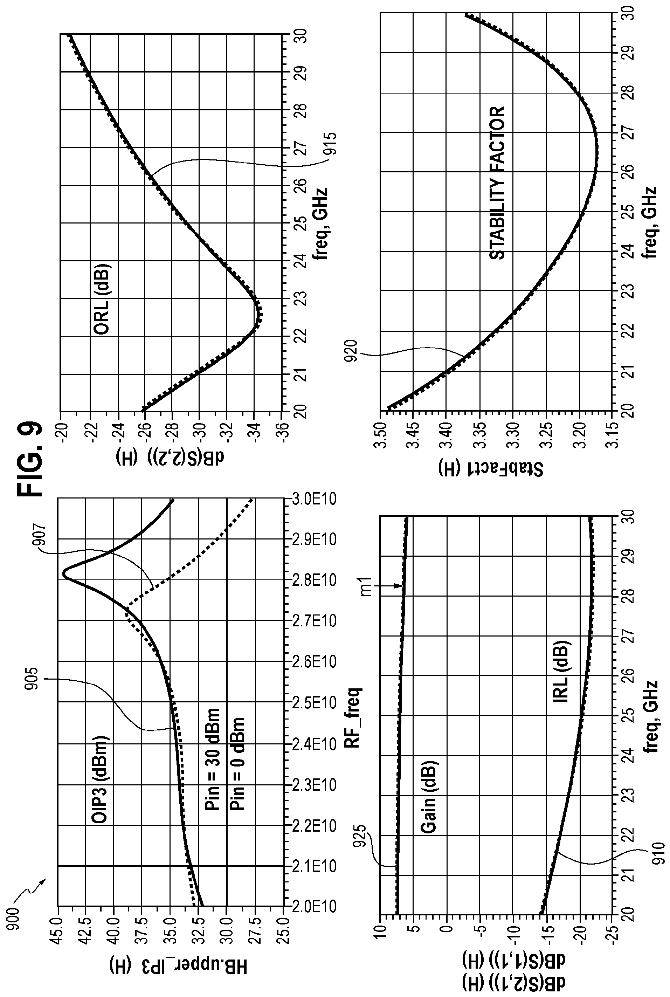

FIG. 9 shows graphs 900 of the linearity parameters of the linearized amplifier with the RF input signal increased to 0 dBm. The OIP3 905 is about 44 dBm at about 28 GHz for the corresponding input power of 0 dBm. The OIP3 907 for an input of -30 dBm is shown for comparison. An increase in OIP3 at higher power is expected as the main device enters gain compression, and the auxiliary device starts to show gain expansion. At 0 dBm input power, the DC power consumption is about 659 mW and the OIP3 is greater than 42 dBm (> 15849 mW). Excellent input RL 910 and output RL 915 as shown have been achieved. Simulated stability factor 920 greater than 3.15 over the frequency range is shown. The gain, S21, 925 gradually decreases from 7 dB at 20 GHz to about 6 dB at 30 GHz. A technology related figure of merit (FoM) for the amplifier, namely the ratio of OIP3 to DC power consumption can be calculated as $FoM = \frac{OIP 3}{DC Power} = \frac{15849}{659} = 24$ This is higher, more than twice as high, than the highest ratio reported for GaAs technology, i.e., about 10. An FoM greater than 15, achieved and exceeded by this embodiment, would be a significant improvement.

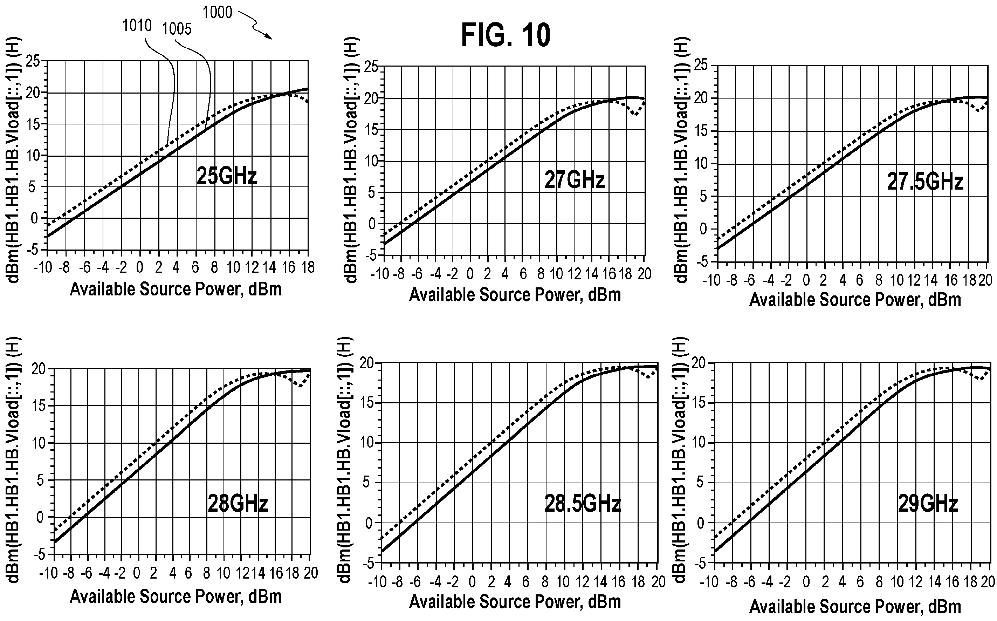

FIG. 10 shows graphs 1000 of output power vs. input power, PIPO, at different frequencies from 25 GHz to 29 GHz for a standard balanced amplifier, e.g., amplifier 400, and linearized balanced amplifiers, e.g., embodiment 100, 600. The input RF signal level is swept from -10 dBm to 20 dBm. The plots 1005 (dark line) show the linearized balanced amplifier and plots 1010 (lighter line) shows the non-linearized balanced amplifier at various frequencies over the input power variations. While the output RF power for the non-linearized amplifier shows saturation, i.e., little or no additional power output for increasing power input, at around 14 dBm, the linearized amplifier does not show output power saturation even at 20 dBm input RF level.

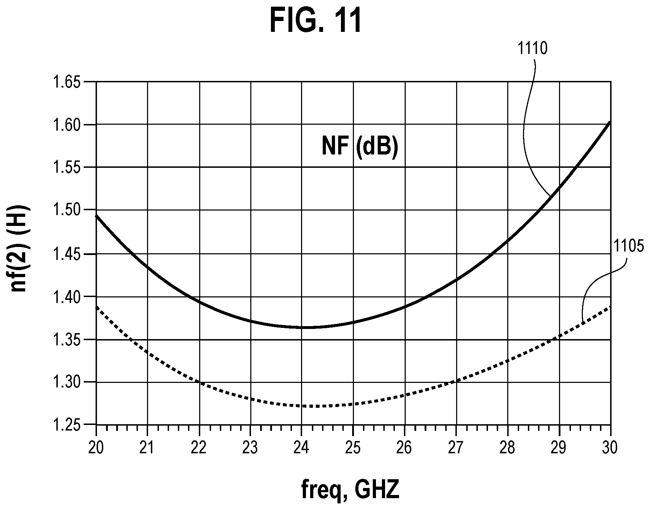

FIG. 11 is a graph of the noise factor, NF, performance of a non-linearized balanced amplifier with a NF 1105 and the linearized balanced amplifier with a NF 1110. As shown, a negligible degradation of about 0.1 dB is observed due to linearization.

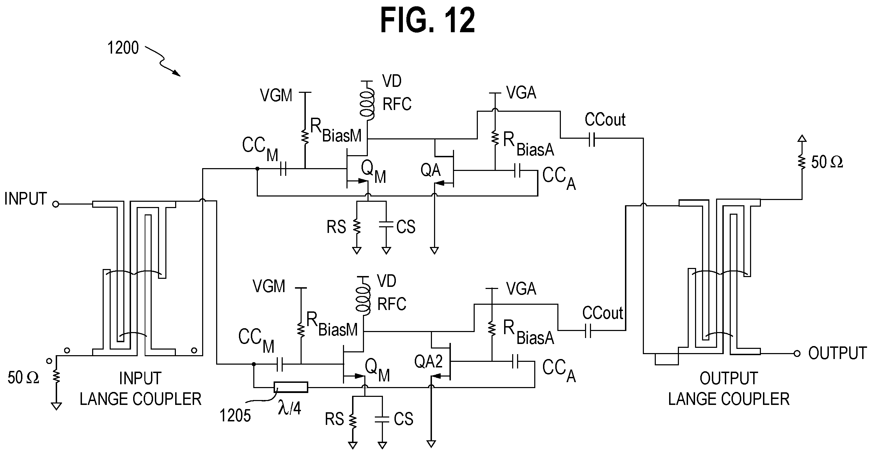

FIG. 12 depicts an exemplary simplified schematic diagram 1200 for the linearized amplifier 200 to achieve dual-mode operation with the 90 degree phase shift line (or shift register for delay) 1205, which corresponds to element 185 in FIG. 2. The main amplifiers are Qm and the auxiliary amplifiers are Qa. Embodiment 1200 shows that separate DC gate voltages (Vga1 and Vga2) can be used to set different operating points for the two auxiliary amplifiers with voltage Vgm setting the operating point ( DC gate voltage) for the main amplifiers. Adjustable DC voltage supplies can furnish Vga1 and Vga2. As explained above, it can be advantageous to set the bias point for the auxiliary amplifier to yield the same third order output current as output by the main amplifier, but with an opposite slope to achieve cancellation of third order nonlinearity products. Also, the shift element 1205 causes an output of two orthogonal components as explained for FIG. 2.

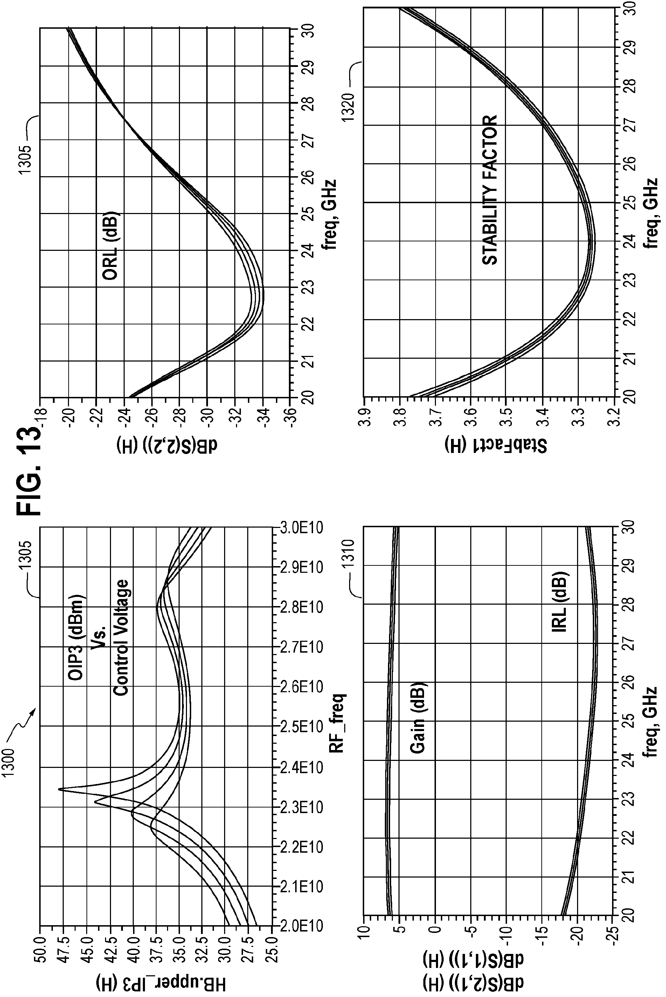

FIG. 13 shows graphs 1300 of the performance of the embodiment 1200 in FIG. 12. Identically sized periphery auxiliary devices were used, and a single variable DC control voltage (for the gate of both auxiliary amplifiers) was utilized to dynamically tune the minimization of OIP3 over 1 GHz bandwidth (about 22.5 GHz - 23.5 GHz) as shown in the plots in graph 1305 where each plot represents a different gate voltage. This is accomplished without adversely affecting amplifier's small signal performance as shown in graphs 1310, 1315 and 1320 where the plots represent the different gate voltages.

FIG. 14 shows graphs 1400 with two distinct modes (frequencies) of operation. To achieve this capability, auxiliary devices with different total peripheries (areas) and different adjusted gate control bias were used. With this arrangement, OIP3 can be improved with minimization peaks of about 40 dBm at close to extreme edges of the bandwidth (at 22 GHz and 28 GHz). As seen, two separate peaks of minimized OIP3 within the bandwidth are achieved. The frequency at which each peak occurs can be controlled by gate bias voltage selection for the auxiliary amplifiers and the gain of the auxiliary amplifiers relative to the gain of the main amplifiers. Such gain can be selected by controlling the periphery of the auxiliary amplifier to produce a gain so that the gm3 current components in Id is the same as produced by the associated main amplifier. The main device has a total periphery of 300 um. The technology-related FoM for this embodiment is given by $FoM = \frac{OIP 3 , mW}{DC Power , mW} = \frac{10000}{656} = 15.2$

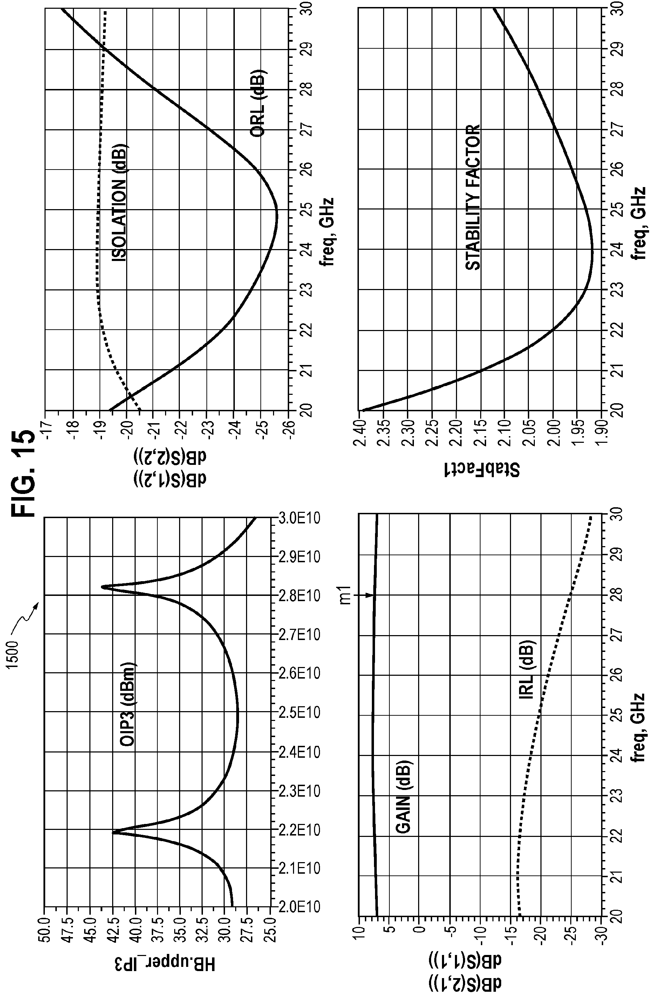

FIG. 15 shows graphs 1500 of the performance of the dual-mode linearized amplifier 1200 in which the main device size (periphery area) has been optimized to reduce parasitic at higher frequencies. A total device periphery of 186 um was used, and a gain greater than 7 dB was achieved up to 30 GHz as shown in graph 1410. Maximum peaks of minimized OIP3 greater than 42 dBm have been simultaneously achieved at 22 GHz and 28 GHz as seen in graph 1405. Reducing device parasitic capacitance and resistance help with maintain gain at higher frequencies. Auxiliary device sizes of 120 um to 280 um have been used.

Embodiments that provide wideband linearization of balanced amplifiers are described. In one embodiment of this invention, auxiliary amplifiers, that are integrated with main amplifiers, are biased to improve the efficiency and linearity of the overall balanced amplifier circuit. One embodiment provides single mode operation (one selectable frequency where linearization peaks). In another embodiment of this invention, dual-mode and multi-mode schemes for linearizing a balanced amplifier are presented, i.e., multiple selectable frequencies at which linearization peaks occur. An exemplary linearized balanced amplifier suitable for operation between 20 - 30 GHz is described which uses 0.15 um GaAs HEMT transistors. This linearized balanced amplifier demonstrates significant improvement in linearity and efficiency in comparison to a non-linearized balanced amplifier. Tunable linearization peaks at a single frequency and simultaneous dual frequencies in a 10 GHz bandwidth (BW) in a 20GHz - 30GHz band are described. A figure-of-merit (FoM) defined as the ratio of OIP3 (third-order intercept at the output) to DC power consumption exceeds 24 for one embodiment, which surpasses a reported ratio of 10 for GaAs HEMT. The PIPO (output RF power vs. input RF power) indicates linearity within the band of operation.

Realization of the above exemplary embodiments with integration of auxiliary amplifiers with main amplifiers in each branch of a balanced amplifier, and preferably optimum device sizing, dynamic bias control, multi-biasing, and implementation of time delay or a phase shift applied to one arm of the balanced amplifier, will result in dynamic linearization of the overall balanced amplifier.

Exemplary embodiments of the present invention are described and shown. Those skilled in the art will appreciate that modifications and substitutions to the embodiment can be made that are still within the scope of the invention as defined in the following claims.

## Claims

1. A radio frequency, RF, amplifier comprising:
first and second main amplifiers (105, 110);
an input coupler (125) that divides an input RF signal into first and second signals, and shifts the second signal to be out of phase with the phase of the first signal;
inputs of the first and second main amplifiers receive, respectively, the first signal and second phase shifted signal;
outputs of the first and second main amplifiers provide, respectively, an amplified first signal and an amplified second phase shifted signal;
first and second auxiliary amplifiers (115, 120) are connected in parallel across the first and second main amplifiers (105, 110), respectively, so that the output of the first auxiliary amplifier is connected to the output of the first main amplifier and the output of the second auxiliary amplifier is connected to the output of the second main amplifier;
an output coupler (135) shifts the combination of the amplified first signal and the output of the first auxiliary amplifier to form a third signal that is substantially in phase with the phase of the amplified second phase shifted signal, the output coupler combines the combination of the amplified second phase shifted signal and the output of the second auxiliary amplifier with the third signal into a single integrated RF output signal;
a phase control device (185) having an input coupled to the input of the second main amplifier and an output coupled to the input of the second auxiliary amplifier, the phase control device shifting the phase of the signal at the output of the phase control device to a phase that is different from the phase of the signal at the input of the phase control device;
the first and second main amplifiers have respective amplified first signal and amplified second phase shifted signal each of which include third order nonlinearity components
where a DC bias for the first and second main amplifiers establish an operating region with a slope that is one of a positive and negative slope for the third order nonlinearity components;
a bias control circuit (175, 180) coupled to the first and second auxiliary amplifiers, the bias control circuit controls the DC operating bias of the first and second auxiliary amplifiers so that each of the amplified outputs from the respective first and second auxiliary amplifier include third order nonlinearity components that is the other of a positive and negative slope so that the third order nonlinearity components in the output signals from the first and second auxiliary amplifiers destructively combine with the corresponding third order nonlinearity components in the output signals from the first and second main amplifiers;
the phase control device (185) providing a phase shift of substantially 90 degrees in the input signal to the second auxiliary amplifier at a certain frequency within the intended bandwidth causing an increased peak in the minimization of third order nonlinearity components at the certain frequency thereby minimizing third order nonlinearity components in the single integrated RF output signal.

2. The RF amplifier of claim 1, wherein the first and second auxiliary amplifiers have a gain such that the magnitudes of the third order nonlinearity components in the outputs of the first and second auxiliary amplifiers are substantially equal to the magnitudes of the third order nonlinearity components in the respective outputs of the first and second main amplifiers to enhance the minimization of third order nonlinearity components in the single integrated RF output signal since slopes of the third order nonlinearity components in the outputs of the first and second auxiliary amplifiers differ from the slopes of the third order nonlinearity components in the outputs of the first and second main amplifiers.

3. The RF amplifier of claim 1 or 2, wherein the first and second auxiliary amplifiers and the first and second main amplifiers have HEMT transistors that provide gain and in which a DC gate voltage controls a corresponding amount of DC drain current, a third derivative of the gate voltage versus the drain current characteristic determines the magnitude of the third order nonlinearity component present in the total drain current of the respective amplifiers, a first voltage source supplies a DC gate voltage for HEMT transistors in the first and second main amplifiers to control the third derivative of the gate voltage versus the drain current characteristic to have one of a positive and negative slope, a second voltage source supplies a DC gate voltage for HEMT transistors in the first and second auxiliary amplifiers to control the third derivative of the gate voltage versus the drain current characteristic to have the other of a positive and negative slope.

4. The RF amplifier of anyone of claim 3, wherein said gain is at frequencies between 20 to 30 GHz.

5. The RF amplifier of claim 1, wherein the phase control device includes at least two phase altering devices each of which provides a phase shift of substantially 90 degrees at respective first and second frequencies within the intended bandwidth causing corresponding increased first and second peaks in the minimization of third order nonlinearity components at the first and second frequencies.

6. The RF amplifier of claim 1 or claim 5, wherein the phase control device is adjustable so that the frequency at which the 90 degree phase shift occurs can be adjusted to be any frequency with the intended bandwidth of frequencies.

7. The RF amplifier of anyone of claims 1-6, wherein the first and second main amplifiers have first and second slopes of third order nonlinearity components in each respective output, the bias control circuit supplies one bias voltage to the first auxiliary amplifier and another bias voltage to the second auxiliary amplifier so that the first and second auxiliary amplifiers have third order nonlinearity components with third and fourth slopes in the respective outputs, the third order nonlinearity components the output with the first slope combining with the third order nonlinearity components in the output with the third slope to substantially cancel, the third order nonlinearity components in the output with the second slope combining with the third order nonlinearity components in the output with the fourth slope to substantially cancel.

8. The RF amplifier of anyone of claims 1-7, wherein a figure of merit, FoM, for the RF amplifier, defined as the ratio of OIP3 to DC power consumption, is greater than 15.

9. A method for minimizing third order nonlinearity components in an output signal of a radio frequency amplifier that amplifies signals in an operational bandwidth of frequencies, the method comprising the steps of:
dividing by an input coupler (125) an input RF signal into first and second signals, where the second signal has a phase that is substantially 90 degrees different from the phase of the first signal;
amplifying the first and second signals by respective first and second main amplifiers to produce amplified first and second signals, respectively, the first and second main amplifiers having a DC operating region in which a slope of third order nonlinearity components in the respective first and second amplified signals is one of a positive and negative slope;
phase shifting, by a phase control device (185) having an input coupled to an input of the second main amplifier and an output coupled to an input of the second auxiliary amplifier, the second signal to provide a phase-controlled signal to the input of the second auxiliary amplifier, the phase control device (185) shifting the phase of the signal at its output to a phase that is different from the phase of the signal at its input;
amplifying the first signal and the phase-controlled signal by respective first and second auxiliary amplifier connected in parallel across the first and second main amplifiers, respectively, so that an output of the first auxiliary amplifier is connected to an output of the first main amplifier and an output of the second auxiliary amplifier is connected to an output of the second main amplifier, to produce amplified third and fourth signals, respectively;
summing the amplified third and fourth signals with the first and second amplified signals, respectively, at the connected outputs to produce fifth and sixth signals, respectively;
shifting with an output coupler (135) the phase of the fifth signal to form a seventh signal that is substantially in phase with the phase of the sixth signal, and summing with the output coupler (135) the seventh and sixth signals into a single integrated RF output signal;
controlling, by a bias control circuit (175, 180) coupled to the first and second auxiliary amplifiers, DC bias of the first and second auxiliary amplifiers so that each has a DC operating region in which a slope of third order nonlinearity components in the third and fourth amplified signals is the other of a positive and negative slope so that the third order nonlinearity components in the third and fourth amplified signals destructively combine with and minimize the corresponding third order nonlinearity components in the first and second amplified signals, respectively;
and providing, by the phase control device (185), a phase shift of substantially 90 degrees in the input signal to the second auxiliary amplifier at a certain frequency within the operational bandwidth, causing an increased peak in the minimization of third order nonlinearity components at the certain frequency, thereby minimizing third order nonlinearity components in the single integrated RF output signal.

10. The method of claim 9, further comprising the first and second auxiliary amplifiers having a gain such that the magnitudes of the third order nonlinearity components in the third and fourth signals are substantially equal to the magnitudes of the third order nonlinearity components in the respective first and second amplifier signals to enhance the minimization of third order nonlinearity components in the single integrated RF output signal since slopes of the third order nonlinearity components in the third and fourth signals differ from the slopes of the third order nonlinearity components in the first and second amplified signals.

11. The method of anyone of claims 9-10, the certain frequency being at least two corresponding frequencies within the intended bandwidth causing corresponding first and second peaks in the minimization of third order nonlinearity components at the at least two frequencies.

## Patentansprüche

1. Hochfrequenz-, HF-, Verstärker, umfassend:
einen ersten und einen zweiten Hauptverstärker (105, 110);
einen Eingangskoppler (125), der ein Eingangs-HF-Signal in ein erstes und ein zweites Signal aufteilt und das zweite Signal so verschiebt, dass es mit der Phase des ersten Signals außer Phase ist;
Eingänge des ersten und des zweiten Hauptverstärkers empfangen jeweils das erste Signal und das zweite phasenverschobene Signal;
Ausgänge des ersten und des zweiten Hauptverstärkers stellen jeweils ein verstärktes erstes Signal und ein verstärktes zweites phasenverschobenes Signal bereit;
der erste und der zweite Hilfsverstärker (115, 120) sind parallel über den ersten bzw. den zweiten Hauptverstärker (105, 110) geschaltet, sodass der Ausgang des ersten Hilfsverstärkers mit dem Ausgang des ersten Hauptverstärkers verbunden ist und der Ausgang des zweiten Hilfsverstärkers mit dem Ausgang des zweiten Hauptverstärkers verbunden ist,
ein Ausgangskoppler (135) verschiebt die Kombination aus dem verstärkten ersten Signal und dem Ausgang des ersten Hilfsverstärkers, um ein drittes Signal zu bilden, das im Wesentlichen in Phase mit der Phase des verstärkten zweiten phasenverschobenen Signals ist, der Ausgangskoppler kombiniert die Kombination aus dem verstärkten zweiten phasenverschobenen Signal und dem Ausgang des zweiten Hilfsverstärkers mit dem dritten Signal zu einem einzigen integrierten HF-Ausgangssignal;
wobei eine Phasensteuervorrichtung (185) einen Eingang, der mit dem Eingang des zweiten Hauptverstärkers gekoppelt ist, und einen Ausgang aufweist, der mit dem Eingang des zweiten Hilfsverstärkers gekoppelt ist, wobei die Phasensteuervorrichtung die Phase des Signals am Ausgang der Phasensteuervorrichtung auf eine Phase verschiebt, die sich von der Phase des Signals am Eingang der Phasensteuervorrichtung unterscheidet;
der erste und der zweite Hauptverstärker weisen jeweils ein verstärktes erstes Signal und ein verstärktes zweites phasenverschobenes Signal auf, die jeweils Nichtlinearitätskomponenten dritter Ordnung enthalten, wobei eine Gleichstromvorspannung für den ersten und den zweiten Hauptverstärker einen Betriebsbereich mit einer Steilheit festlegt, die für die Nichtlinearitätskomponenten dritter Ordnung entweder eine positive oder eine negative Steilheit ist;
eine Vorspannungssteuerschaltung (175, 180), die mit dem ersten und dem zweiten Hilfsverstärker gekoppelt ist, wobei die Vorspannungssteuerschaltung die Gleichstrombetriebsvorspannung des ersten und des zweiten Hilfsverstärkers so steuert, dass jeder der verstärkten Ausgänge aus dem jeweiligen ersten und zweiten Hilfsverstärker Nichtlinearitätskomponenten dritter Ordnung enthält, die die andere Steilheit, entweder positiv oder negativ, ist, sodass sich die Nichtlinearitätskomponenten dritter Ordnung in den Ausgangssignalen aus dem ersten und dem zweiten Hilfsverstärker destruktiv mit den entsprechenden Nichtlinearitätskomponenten dritter Ordnung in den Ausgangssignalen aus dem ersten und dem zweiten Hauptverstärker kombinieren;
wobei die Phasensteuervorrichtung (185) eine Phasenverschiebung um im Wesentlichen 90 Grad im Eingangssignal an den zweiten Hilfsverstärker bei einer bestimmten Frequenz innerhalb der vorgesehenen Bandbreite bereitstellt, was zu einer erhöhten Spitze bei der Minimierung von Nichtlinearitätskomponenten dritter Ordnung bei der bestimmten Frequenz führt, wodurch Nichtlinearitätskomponenten dritter Ordnung im einzelnen integrierten HF-Ausgangssignal minimiert werden.

2. HF-Verstärker nach Anspruch 1, wobei der erste und der zweite Hilfsverstärker eine solche Verstärkung aufweisen, dass die Größen der Nichtlinearitätskomponenten dritter Ordnung in den Ausgängen des ersten und des zweiten Hilfsverstärkers im Wesentlichen gleich den Größen der Nichtlinearitätskomponenten dritter Ordnung in den jeweiligen Ausgängen des ersten und des zweiten Hauptverstärkers sind, um die Minimierung der Nichtlinearitätskomponenten dritter Ordnung im einzelnen integrierten HF-Ausgangssignal zu verbessern, da sich die Steilheiten der Nichtlinearitätskomponenten dritter Ordnung in den Ausgängen des ersten und des zweiten Hilfsverstärkers von den Steilheiten der Nichtlinearitätskomponenten dritter Ordnung in den Ausgängen des ersten und des zweiten Hauptverstärkers unterscheiden.

3. HF-Verstärker nach Anspruch 1 oder 2, wobei der erste und der zweite Hilfsverstärker und der erste und der zweite Hauptverstärker HEMT-Transistoren aufweisen, die eine Verstärkung bereitstellen und in denen eine Gleichstrom-Gate-Spannung eine entsprechende Menge an Gleichstrom-Drainstrom steuert, wobei eine dritte Ableitung der Gate-Spannung im Verhältnis zur Drainstromkennlinie die Größe der im Gesamt-Drainstrom der jeweiligen Verstärker vorhandenen Nichtlinearitätskomponente dritter Ordnung bestimmt, eine erste Spannungsquelle eine Gleichstrom-Gate-Spannung für HEMT-Transistoren im ersten und zweiten Hauptverstärker bereitstellt, um die dritte Ableitung der Gate-Spannung im Verhältnis zur Drainstromkennlinie so zu steuern, dass sie entweder eine positive oder eine negative Steilheit aufweist, eine zweite Spannungsquelle eine Gleichstrom-Gate-Spannung für HEMT-Transistoren im ersten und zweiten Hilfsverstärker bereitstellt, um die dritte Ableitung der Gate-Spannung im Verhältnis zur Drainstromkennlinie so zu steuern, dass sie die andere Steilheit, also entweder positiv oder negativ, aufweist.

4. HF-Verstärker nach einem der Ansprüche 3, wobei die Verstärkung bei Frequenzen zwischen 20 und 30 GHz liegt.

5. HF-Verstärker nach Anspruch 1, wobei die Phasensteuervorrichtung mindestens zwei Phasenänderungsvorrichtungen enthält, von denen jede eine Phasenverschiebung um im Wesentlichen 90 Grad bei der jeweiligen ersten und zweiten Frequenz innerhalb der vorgesehenen Bandbreite bereitstellt, was zu entsprechenden erhöhten ersten und zweiten Spitzen bei der Minimierung von Nichtlinearitätskomponenten dritter Ordnung bei der ersten und zweiten Frequenz führt.

6. HF-Verstärker nach Anspruch 1 oder Anspruch 5, wobei die Phasensteuervorrichtung so einstellbar ist, dass die Frequenz, bei der die 90-Grad-Phasenverschiebung auftritt, auf eine beliebige Frequenz innerhalb der vorgesehenen Bandbreite von Frequenzen eingestellt werden kann.

7. HF-Verstärker nach einem der Ansprüche 1-6, wobei der erste und der zweite Hauptverstärker erste und zweite Steilheiten von Nichtlinearitätskomponenten dritter Ordnung in jedem jeweiligen Ausgang aufweisen, die Vorspannungssteuerschaltung eine Vorspannung an den ersten Hilfsverstärker und eine andere Vorspannung an den zweiten Hilfsverstärker bereitstellt, sodass der erste und der zweite Hilfsverstärker Nichtlinearitätskomponenten dritter Ordnung mit dritten und vierten Steilheiten in den jeweiligen Ausgängen aufweisen, wobei sich die Nichtlinearitätskomponenten dritter Ordnung im Ausgang mit der ersten Steilheit mit den Nichtlinearitätskomponenten dritter Ordnung im Ausgang mit der dritten Steilheit so kombinieren, dass sie sich im Wesentlichen aufheben, wobei sich die Nichtlinearitätskomponenten dritter Ordnung im Ausgang mit der zweiten Steilheit mit den Nichtlinearitätskomponenten dritter Ordnung im Ausgang mit der vierten Steilheit so kombinieren, dass sie sich im Wesentlichen aufheben.

8. HF-Verstärker nach einem der Ansprüche 1-7, wobei eine Gütezahl, FoM-(Figure Of Merit), für den HF-Verstärker, definiert als das Verhältnis von OIP3 zur Gleichstromleistungsaufnahme, größer als 15 ist.

9. Verfahren zum Minimieren von Nichtlinearitätskomponenten dritter Ordnung in einem Ausgangssignal eines Hochfrequenzverstärkers, der Signale in einer Betriebsbandbreite von Frequenzen verstärkt, wobei das Verfahren die folgenden Schritte umfasst:
Teilen eines HF-Eingangssignals durch einen Eingangskoppler (125) in ein erstes und ein zweites Signal, wobei das zweite Signal eine Phase aufweist, die sich im Wesentlichen um 90 Grad von der Phase des ersten Signals unterscheidet;
Verstärken des ersten und des zweiten Signals durch den jeweiligen ersten und zweiten Hauptverstärker, um jeweils ein verstärktes erstes und zweites Signal zu erzeugen, wobei der erste und der zweite Hauptverstärker einen GleichstromBetriebsbereich aufweisen, in dem eine Steilheit von Nichtlinearitätskomponenten dritter Ordnung im jeweiligen ersten und zweiten verstärkten Signal entweder eine positive oder eine negative Steilheit ist;
Phasenverschieben, durch eine Phasensteuervorrichtung (185), die einen Eingang, der mit einem Eingang des zweiten Hauptverstärkers gekoppelt ist, und einen Ausgang aufweist, der mit einem Eingang des zweiten Hilfsverstärkers gekoppelt ist, wobei das zweite Signal ein phasengesteuertes Signal an den Eingang des zweiten Hilfsverstärkers bereitstellt, wobei die Phasensteuervorrichtung (185) die Phase des Signals an ihrem Ausgang auf eine Phase verschiebt, die sich von der Phase des Signals an ihrem Eingang unterscheidet;
Verstärken des ersten Signals und des phasengesteuerten Signals durch einen jeweiligen ersten und zweiten Hilfsverstärker, die parallel über den ersten bzw. den zweiten Hauptverstärker geschaltet sind, sodass ein Ausgang des ersten Hilfsverstärkers mit einem Ausgang des ersten Hauptverstärkers verbunden ist und ein Ausgang des zweiten Hilfsverstärkers mit einem Ausgang des zweiten Hauptverstärkers verbunden ist,
um ein verstärktes drittes bzw. viertes Signal zu erzeugen;
Summieren des verstärkten dritten und vierten Signals mit dem ersten bzw. zweiten verstärkten Signal an den verbundenen Ausgängen, um ein fünftes bzw. sechstes Signal zu erzeugen;
Verschieben der Phase des fünften Signals mit einem Ausgangskoppler (135), um ein siebtes Signal zu bilden, das im Wesentlichen in Phase mit der Phase des sechsten Signals ist, und Summieren des siebten und des sechsten Signals mit dem Ausgangskoppler (135) zu einem einzigen integrierten HF-Ausgangssignal;
Steuern der Gleichstromvorspannung des ersten und zweiten Hilfsverstärkers durch eine Vorspannungssteuerschaltung (175, 180), die mit dem ersten und zweiten Hilfsverstärker gekoppelt ist, sodass jeder einen Gleichstrombetriebsbereich aufweist, in dem eine Steilheit von Nichtlinearitätskomponenten dritter Ordnung im dritten und vierten verstärkten Signal die andere Steilheit, entweder positiv oder negativ, ist, sodass sich die Nichtlinearitätskomponenten dritter Ordnung im dritten und vierten verstärkten Signal destruktiv mit den entsprechenden Nichtlinearitätskomponenten dritter Ordnung im ersten bzw. zweiten verstärkten Signal kombinieren und diese minimieren;
und Bereitstellen einer Phasenverschiebung um im Wesentlichen 90 Grad im Eingangssignal an den zweiten Hilfsverstärker bei einer bestimmten Frequenz innerhalb der Betriebsbandbreite durch die Phasensteuervorrichtung (185), was zu einer erhöhten Spitze bei der Minimierung von Nichtlinearitätskomponenten dritter Ordnung bei der bestimmten Frequenz führt, wodurch Nichtlinearitätskomponenten dritter Ordnung im einzelnen integrierten HF-Ausgangssignal minimiert werden.

10. Verfahren nach Anspruch 9, ferner umfassend den ersten und den zweiten Hilfsverstärker, die eine Verstärkung aufweisen, sodass die Größen der Nichtlinearitätskomponenten dritter Ordnung im dritten und vierten Signal im Wesentlichen gleich den Größen der Nichtlinearitätskomponenten dritter Ordnung im jeweiligen ersten und zweiten Verstärkersignal sind, um die Minimierung von Nichtlinearitätskomponenten dritter Ordnung im einzelnen integrierten HF-Ausgangssignal zu verbessern, da sich die Steilheiten der Nichtlinearitätskomponenten dritter Ordnung im dritten und vierten Signal von den Steilheiten der Nichtlinearitätskomponenten dritter Ordnung im ersten und zweiten verstärkten Signal unterscheiden.

11. Verfahren nach einem der Ansprüche 9-10, wobei es sich bei der bestimmten Frequenz um mindestens zwei entsprechende Frequenzen innerhalb der vorgesehenen Bandbreite sind, die entsprechende erste und zweite Spitzen bei der Minimierung von Nichtlinearitätskomponenten dritter Ordnung bei den mindestens zwei Frequenzen verursachen.

## Revendications

1. Amplificateur de radiofréquence, RF, comprenant :
des premier et deuxième amplificateurs principaux (105, 110) ;
un coupleur d'entrée (125) qui divise un signal RF d'entrée en des premier et deuxième signaux, et décale le deuxième signal pour être déphasé par rapport à la phase du premier signal ;
des entrées des premier et deuxième amplificateurs principaux reçoivent, respectivement, le premier signal et le deuxième signal déphasé ;
des sorties des premier et deuxième amplificateurs principaux fournissent, respectivement, un premier signal amplifié et un deuxième signal déphasé amplifié ;
des premier et deuxième amplificateurs auxiliaires (115, 120) sont connectés en parallèle respectivement aux bornes des premier et deuxième amplificateurs principaux (105, 110), de sorte que la sortie du premier amplificateur auxiliaire soit connectée à la sortie du premier amplificateur principal et que la sortie du deuxième amplificateur auxiliaire soit connectée à la sortie du deuxième amplificateur principal ;
un coupleur de sortie (135) décale la combinaison du premier signal amplifié et de la sortie du premier amplificateur auxiliaire pour former un troisième signal qui est sensiblement en phase avec la phase du deuxième signal déphasé amplifié, le coupleur de sortie combine la combinaison du deuxième signal déphasé amplifié et de la sortie du deuxième amplificateur auxiliaire avec le troisième signal en un signal de sortie RF intégré unique ;
un dispositif de commande de phase (185) dont l'entrée est couplée à l'entrée du deuxième amplificateur principal et dont la sortie est couplée à l'entrée du deuxième amplificateur auxiliaire, le dispositif de commande de phase décalant la phase du signal à la sortie du dispositif de commande de phase vers une phase qui est différente de la phase du signal à l'entrée du dispositif de commande de phase ;
les premier et deuxième amplificateurs principaux comportent respectivement un premier signal amplifié et un deuxième signal déphasé amplifié, chacun desquels comporte des composantes de non-linéarité du troisième ordre, où une polarisation en courant continu pour les premier et deuxième amplificateurs principaux établit une zone de fonctionnement avec une pente qui est l'une parmi une pente positive et une pente négative pour les composantes de non-linéarité du troisième ordre ;
un circuit de commande de polarisation (175, 180) couplé aux premier et deuxième amplificateurs auxiliaires, le circuit de commande de polarisation commande la polarisation de fonctionnement en courant continu des premier et deuxième amplificateurs auxiliaires de telle sorte que chacune des sorties amplifiées des premier et deuxième amplificateurs auxiliaires respectifs comporte des composantes de non-linéarité du troisième ordre dont la pente est l'autre parmi une pente positive et une pente négative de telle sorte que les composantes de non-linéarité du troisième ordre dans les signaux de sortie des premier et deuxième amplificateurs auxiliaires se combinent de manière destructive avec les composantes de non-linéarité du troisième ordre dans les signaux de sortie des premier et deuxième amplificateurs principaux ;
le dispositif de commande de phase (185) fournissant un déphasage de sensiblement 90 degrés dans le signal d'entrée vers le deuxième amplificateur auxiliaire à une certaine fréquence comprise dans la bande passante prévue, provoquant un pic accru dans la minimisation de composantes de non-linéarité du troisième ordre à cette certaine fréquence, minimisant ainsi les composantes de non-linéarité du troisième ordre dans le signal de sortie RF intégré unique.

2. Amplificateur RF selon la revendication 1, dans lequel les premier et deuxième amplificateurs auxiliaires présentent un gain tel que les amplitudes des composantes de non-linéarité du troisième ordre dans les sorties des premier et deuxième amplificateurs auxiliaires sont sensiblement égales aux amplitudes des composantes de non-linéarité du troisième ordre dans les sorties respectives des premier et deuxième amplificateurs principaux, afin d'améliorer la minimisation de composantes de non-linéarité du troisième ordre dans le signal de sortie RF intégré unique, puisque les pentes des composantes de non-linéarité du troisième ordre dans les sorties des premier et deuxième amplificateurs auxiliaires diffèrent des pentes des composantes de non-linéarité du troisième ordre dans les sorties des premier et deuxième amplificateurs principaux.

3. Amplificateur RF selon la revendication 1 ou 2, dans lequel les premier et deuxième amplificateurs auxiliaires et les premier et deuxième amplificateurs principaux comportent des transistors HEMT qui fournissent un gain et dans lesquels une tension de grille en courant continu commande une valeur correspondante de courant de drain en courant continu, une dérivée troisième de la caractéristique de tension de grille en fonction du courant de drain détermine l'amplitude de la composante de non-linéarité du troisième ordre présente dans le courant de drain total des amplificateurs respectifs, une première source de tension fournit une tension de grille en courant continu aux transistors HEMT dans les premier et deuxième amplificateurs principaux afin de contrôler la dérivée troisième de la caractéristique de tension de grille en fonction du courant de drain de manière à ce qu'elle présente une parmi une pente positive et une pente négative, une deuxième source de tension fournit une tension de grille en courant continu aux transistors HEMT dans les premier et deuxième amplificateurs auxiliaires afin de commander la dérivée troisième de la caractéristique de tension de grille en fonction du courant de drain de manière à ce qu'elle présente l'autre pente parmi une pente positive et une pente négative.

4. Amplificateur RF selon la revendication 3, dans lequel ledit gain est à des fréquences comprises entre 20 et 30 GHz.

5. Amplificateur RF selon la revendication 1, dans lequel le dispositif de commande de phase comprend au moins deux dispositifs de modification de phase dont chacun fournit un déphasage de sensiblement 90 degrés à des première et deuxième fréquences respectives à l'intérieur de la bande passante prévue, provoquant ainsi une augmentation correspondante des premier et deuxième pics dans la minimisation de composantes de non-linéarité du troisième ordre aux première et deuxième fréquences.

6. Amplificateur RF selon la revendication 1 ou la revendication 5, dans lequel le dispositif de commande de phase est réglable de sorte que la fréquence à laquelle se produit le déphasage de 90 degrés puisse être réglée pour correspondre à n'importe quelle fréquence comprise dans la bande passante de fréquences prévue.

7. Amplificateur RF selon l'une quelconque des revendications 1 à 6, dans lequel les premier et deuxième amplificateurs principaux présentent des première et deuxième pentes de composantes de non-linéarité du troisième ordre dans chaque sortie respective, le circuit de commande de polarisation fournit une tension de polarisation au premier amplificateur auxiliaire et une autre tension de polarisation au deuxième amplificateur auxiliaire de sorte que les premier et deuxième amplificateurs auxiliaires présentent des composantes de non-linéarité du troisième ordre avec des troisième et quatrième pentes dans les sorties respectives, les composantes de non-linéarité du troisième ordre dans la sortie avec la première pente se combinant avec les composantes de non-linéarité du troisième ordre dans la sortie avec la troisième pente pour s'annuler sensiblement, et les composantes de non-linéarité du troisième ordre dans la sortie avec la deuxième pente se combinant avec les composantes de non-linéarité du troisième ordre dans la sortie avec la quatrième pente pour s'annuler sensiblement.

8. Amplificateur RF selon l'une quelconque des revendications 1 à 7, dans lequel un facteur de mérite, FoM, de l'amplificateur RF, défini comme le rapport entre OIP3 et la consommation électrique en courant continu, est supérieur à 15.

9. Procédé de minimisation de composantes de non-linéarité du troisième ordre dans un signal de sortie d'un amplificateur radiofréquence qui amplifie des signaux dans une bande passante opérationnelle de fréquences, le procédé comprenant les étapes suivantes :
la division, par un coupleur d'entrée (125), d'un signal RF d'entrée en des premier et deuxième signaux, où le deuxième signal présente une phase qui diffère sensiblement de 90 degrés par rapport à la phase du premier signal ;
l'amplification des premier et deuxième signaux par des premier et deuxième amplificateurs principaux respectifs pour produire respectivement des premier et deuxième signaux amplifiés, les premier et deuxième amplificateurs principaux présentant une région de fonctionnement en courant continu dans laquelle une pente de composantes de non-linéarité du troisième ordre dans les premier et deuxième signaux amplifiés respectifs est l'une parmi une pente positive et une pente négative ;
le déphasage, par un dispositif de commande de phase (185) présentant une entrée couplée à une entrée du deuxième amplificateur principal et une sortie couplée à une entrée du deuxième amplificateur auxiliaire, le deuxième signal étant destiné à fournir un signal commandée en phase à l'entrée du deuxième amplificateur auxiliaire, le dispositif de commande de phase (185) décalant la phase du signal à sa sortie vers une phase qui est différente de la phase du signal à son entrée ;
l'amplification du premier signal et du signal commandé en phase par des premier et deuxième amplificateurs auxiliaires respectifs, connectés en parallèle respectivement aux premier et deuxième amplificateurs principaux, de sorte qu'une sortie du premier amplificateur auxiliaire soit connectée à une sortie du premier amplificateur principal et qu'une sortie du deuxième amplificateur auxiliaire soit connectée à une sortie du deuxième amplificateur principal,
afin de produire respectivement des troisième et quatrième signaux amplifiés ;
la sommation des troisième et quatrième signaux amplifiés avec les premier et deuxième signaux amplifiés, respectivement, au niveau des sorties connectées afin de produire respectivement des cinquième et sixième signaux ;
le décalage avec un coupleur de sortie (135) de la phase du cinquième signal pour former un septième signal qui est sensiblement en phase avec la phase du sixième signal, et la sommation avec le coupleur de sortie (135) des septième et sixième signaux en un signal de sortie RF intégré unique ;
la commande, par un circuit de commande de polarisation (175, 180) couplé aux premier et deuxième amplificateurs auxiliaires, de la polarisation en courant continu des premier et deuxième amplificateurs auxiliaires de telle sorte que chacun présente une zone de fonctionnement en courant continu dans laquelle une pente de composantes de non-linéarité du troisième ordre dans les troisième et quatrième signaux amplifiés est l'autre parmi une pente positive et une pente négative, de sorte que les composantes de non-linéarité du troisième ordre dans les troisième et quatrième signaux amplifiés se combinent de manière destructive avec les composantes de non-linéarité du troisième ordre correspondantes dans les premier et deuxième signaux amplifiés, respectivement, et les minimisent ;
et la fourniture, par le dispositif de commande de phase (185), d'un déphasage de sensiblement 90 degrés dans le signal d'entrée vers le deuxième amplificateur auxiliaire à une certaine fréquence comprise dans la bande passante de fonctionnement, provoquant un pic accru dans la minimisation de composantes de non-linéarité du troisième ordre à cette certaine fréquence, minimisant ainsi les composantes de non-linéarité du troisième ordre dans le signal de sortie RF intégré unique.

10. Procédé selon la revendication 9, comprenant en outre les premier et deuxième amplificateurs auxiliaires présentant un gain tel que les amplitudes des composantes de non-linéarité du troisième ordre dans les troisième et quatrième signaux sont sensiblement égales aux amplitudes des composantes de non-linéarité du troisième ordre dans les signaux respectifs des premier et deuxième amplificateurs, afin d'améliorer la minimisation des composantes de non-linéarité du troisième ordre dans le signal de sortie RF intégré unique, puisque les pentes des composantes de non-linéarité du troisième ordre dans les troisième et quatrième signaux diffèrent des pentes des composantes de non-linéarité du troisième ordre dans les premier et deuxième signaux amplifiés.

11. Procédé selon l'une quelconque des revendications 9 à 10, la certaine fréquence étant au moins deux fréquences correspondantes dans la bande passante prévue, provoquant des premier et deuxième pics correspondants dans la minimisation de composantes de non-linéarité du troisième ordre aux au moins deux fréquences.
